# EUROPEAN PATENT SPECIFICATION

(11) **EP 1 226 447 B1**
(45) Date of publication and mention of the grant of the patent: **16.06.2004**
(21) Application number: 00975312.0
(22) Date of filing: 20.10.2000
(51) Int. Cl.: G01R 31/319

(54) **HIGH RESOLUTION SKEW DETECTION APPARATUS AND METHOD**
HOCHAUFLÖSENDE VORRICHTUNG UND VERFAHREN ZUR ERMITTLUNG VON TAKTVERSCHIEBUNGEN
PROCEDE ET APPAREIL DE DESALIGNEMENT DE SIGNAUX A HAUTE RESOLUTION

(30) Priority: 26.10.1999 US 427433
(43) Date of publication of application: 31.07.2002
(73) Proprietor: TERADYNE, INC., Boston, Massachusetts 02118 (US)
(72) Inventor: HAUPTMAN, Steven, Camarillo, CA 93010 (US); CHUNG, Edgar N., San Marino, California 91108 (US)
(74) Representative: Luckhurst, Anthony Henry William
(86) International application number: PCT/US2000/028999
(87) International publication number: WO 2001/033240

(56) References cited:
- US-A- 5 471 145
- US-A- 5 696 951
- FELDMAN R K: "A NOVEL INSTRUMENT FOR ACCURATE TIME MEASUREMENT IN AUTOMATIC CALIBRATION OF TEST SYSTEMS" PROCEEDINGS OF THE INTERNATIONAL TEST CONFERENCE,US,NEW YORK, IEEE, vol. -, 1993, pages 544-551, XP000437163

## Description

### FIELD OF THE INVENTION

The invention relates generally to automatic test equipment for testing semiconductor devices, and more particularly a high resolution skew detection system and method for timing calibration and/or timing verification on the equipment.

### BACKGROUND OF THE INVENTION

The manufacture of semiconductor devices involves numerous processes that are carefully controlled to maximize throughput and device yields. One of the more important process steps employs automatic test equipment to confirm device functionality. The tests are often performed both at the wafer and packaged-device levels. Generally, the testing procedure includes the application and capture of tester waveforms to and from each device along tester channels, and a determination of whether the captured signals match expected values. The tester channels employ transmission lines to couple the tester to the DUT pins.

In order to successfully test a device-under-test (DUT), signals that are applied to the device pins along each transmission line must arrive at precise timings relative to each other. The transmission lines that route the tester signals to the DUT typically vary in length, contributing small but important relative delays in the propagation time for each signal. Consequently, in order to accurately control the signal timings, the delays for each channel generally must be known and compensated for prior to test in a timing calibration procedure.

One of the primary ways of determining the relative signal delays between tester channels involves driving signals along each channel transmission line and measuring the relative edge-to-edge timing variation, or skew. Once the skews are known, the timings for each signal can be manipulated to align the edges as required to achieve the desired timing accuracy at the DUT pins.

Many techniques are known in the art for measuring the relative skews between propagating tester signals. For example, one of the more popular methods for detecting skew, commonly referred to as the Vernier calibration technique, employs a D-flip-flop-based latching comparator. A target signal is input to the data port of the flip-flop and a reference signal applied to the strobe port. Using this technique, the reference signal simply latches a high or low value based on the skew of the two signals. By using a reference oscillator with a slightly differing frequency or time position, enough information can be gathered from the output to determine the relative magnitude of the skew.

Another flip-flop-based technique for detecting skew employs an XOR gate coupled with a plurality of D-flip-flops, such as the Model AD9901 Phase/Frequency Discriminator available from Analog Devices Corporation. This construction produces a signal with a varying pulsewidth based on the skew magnitude as well as the signal skew polarity. When used in combination with a charge pump, this circuit can also provide a DC signal representing the level of skew detected.

Similar to the XOR-charge pump configuration described above, another skew detection scheme, proposed by Feldman, utilizes a Set-Reset (SR) flip-flop with a charge pump disposed at the output. The SR flip-flop is configured such that the reference signal clocks the flip-flop while the target signal feeds the SET port. The DATA port is held low throughout circuit operation. This particular circuit has an added benefit in that most of the voltage dependent elements such as curent sources, switches, capacitors, etc. have a relatively constant voltage applied to them. This minimizes non-linearity problems.

While the flip-flop-based skew detection schemes described above are beneficial for their intended applications, they all have limited linear ranges because of metastability, or jitter. This is an inherent characteristic of flip-flops as they produce valid UP and DOWN signals. As a result, at higher frequencies of operation, the resolution of the detector degrades to the point at signal-signal skews are undetectable.

In an effort to avoid the metastability problems inherent in flip-flop-based skew detectors, a proposal by Otsuji utilizes a time-to-voltage conversion technique suitable for implementation on an integrated circuit. The technique employs a level converter block for receiving and normalizing a reference signal and a tester signal from one channel of a semiconductor tester. The outputs from the level converter block are coupled to the inputs of a differential amplifier. The amplifier produces a pulse having an amplitude proportional to the relative skew between the reference signal and the tester signal. The pulse is fed to a complementary D-latch, while strobe circuitry generates a strobe synchronously with the rising edges of one of the input signals. The output levels of the Q and Q/ ports are fixed to complementary logic levels according to the skew polarity.

While this circuit has the benefit in that an in-phase skew can be successfully transformed into the differential voltage even for very small skews, no provisions are provided for out-of-phase skews. With the expanding implementation of differential tester channels in semiconductor testers, out-of-phase skew detection is becoming increasingly important.

US Patent number 5,969,951 discloses a signal de-skewing system for a synchronous logic circuit.

In relation to the skew detection scheme proposed by Feldman, see."A novel instrument for accurate time measurement in automatic calibration of test systems" by R.K. Feldman in Proceedings of the International Test Conference, US, New York, IEEE, 1993, pages 544-551, XP000437163.

The conventional skew detection configurations and techniques described above illustrate the limits in achieving timing calibration and verification accuracies. Equally important however is the undesirable duration of the conventional timing calibration and/or verification procedure. Typically, once a tester has completed its calibration, an independent verification apparatus is employed to confirm the accuracy thereof. Usually, a robotic probe disposed proximate the DUT separately steps , through each channel in an effort to detect channel-to-channel skew. Unfortunately. with modern testers employing anywhere from three-thousand to six-thousand channels, the conventional data acquisition time for a robotic probe may take upwards of fourteen hours or more. This results in lost tester time for production purposes, and correspondingly lower overall throughput.

What is needed and heretofore unavailable is a high resolution skew detection circuit and method for use in a semiconductor tester that accurately detects very small skews and provides an output signal that allows for rapid timing calibration verification. The high resolution skew detection circuit and method of the present invention satisfies these needs.

### SUMMARY OF THE INVENTION

The high resolution skew detection circuit and method of the present invention provides an accurate detection of both in-phase and out-of-phase signal skews without the undesirable effects of metastable jitter. Moreover, the invention enables high throughput in a production environment by allowing straightforward measurements on multiple channels and devices in parallel.

To realize the foregoing advantages, the invention in one form comprises a high resolution skew detector including multi-phase input circuitry. The input circuitry has a reference signal input and a skew signal input and is adapted for receiving in-phase and/or out of phase skew signals. In response to a control signal, the input circuitry is operative to pass or invert the skew signals. The detector also includes time-to-voltage conversion circuitry having respective first and second inputs for receiving the skewed and reference signals, and a differential amplifier for generating a relative skew signal. The relative skew signal represents the relative skew between the reference signal and the skew signal. Capture circuitry is coupled to the output of the time-to-voltage conversion circuitry for detecting the relative skew signal.

In another form, the invention comprises a skew detection circuit for measuring the relative skew between a plurality of propagating signals and a reference signal. The skew detection circuit includes a selector circuit having a plurality of inputs adapted for receiving the propagating signals and an output for selectively passing one of the plurality of signals for comparison with the reference signal. The skew detection circuit employs a high resolution skew detector including multi-phase input circuitry. The input circuitry has a reference signal input and a skew signal input and is adapted for receiving in-phase and/or out of phase skew signals. In response to a control signal, the input circuitry is operative to pass or invert the skew signals. The detector also includes time-to-voltage conversion circuitry having respective first and second inputs for receiving the skewed and reference signals, and a differential amplifier for generating a relative skew signal. The relative skew signal represents the relative skew between the reference signal and the skew signal. Capture circuitry is coupled to the output of the time-to-voltage conversion circuitry for detecting the relative skew signal.

In yet another form, the invention comprises a method of determining the relative skew between a plurality of tester channels to compensate for signal propagation delays. The method includes the steps of generating tester signals along the plurality of channels; coupling the channels to a high resolution skew detection circuit comprising multi-phase input circuitry; supplying a reference signal to the skew detection circuit; and selecting one of the tester signals; using the multi-phase input circuitry to pass or invert said selected tester signal in response to a control signal; comparing the selected tester signal against the reference signal on the skew detection circuit. The comparing step includes the steps of converting the relative time difference between an edge of the reference signal and an edge of the passed tester signal to a voltage, and providing the voltage at an output for use as a measurement of the relative skew between the tester signal and the reference signal.

Other features and advantages of the present invention will be apparent from the following detailed description when read in conjunction with the accompanying drawings.

### BRIEF DESCRIPTION OF THE DRAWINGS

The invention will be better understood by reference to the following more detailed description and accompanying drawings in which
FIG. 1 is a partial block diagram of a semiconductor tester employing one embodiment of the present invention;
FIG. 2 is a high level block diagram of the skew detection circuit shown in Figure 1;
FIG. 3 is a partial schematic of one embodiment of a selector circuit for use in the skew detection circuit of Figure 2;
FIG. 4 is a schematic of a high resolution skew detector according to one embodiment of the present invention; and
FIG. 5 is a timing diagram for the high resolution skew detector of Figure 4.

### DETAILED DESCRIPTION OF THE INVENTION

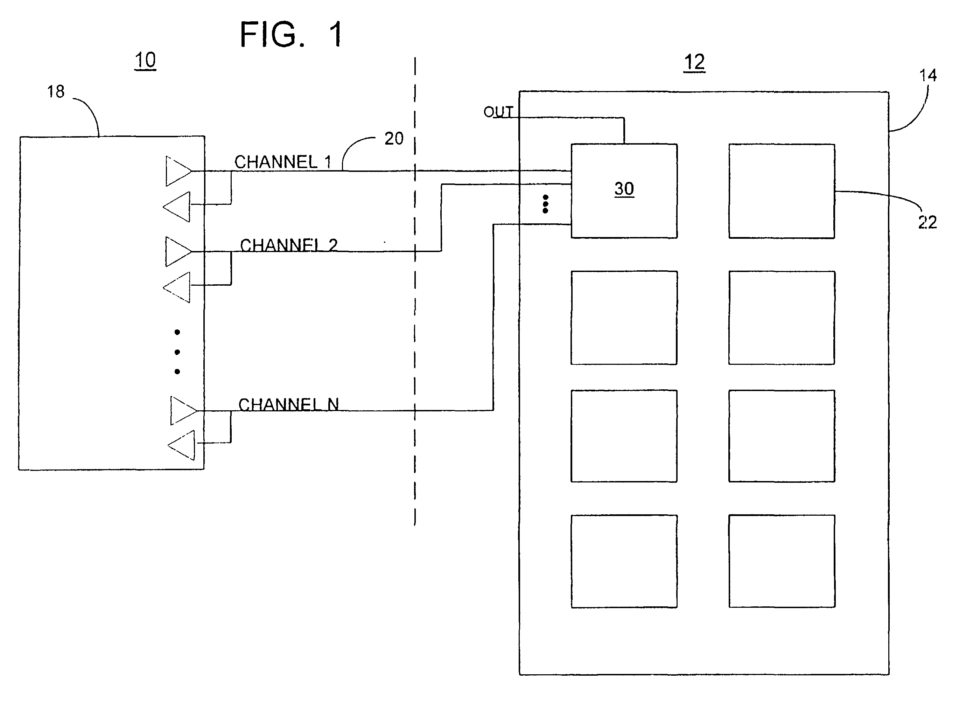

Referring now to Figure 1, a semiconductor tester 10 is shown coupled to a handling apparatus 12 that includes a device interface board (DIB) 14. The tester includes a testhead (not shown) that houses a plurality of pin electronics channel cards 18 for generating tester waveforms along a plurality of channels 20. The channels direct the waveforms to the input pins of one or more DUTs (not shown), and receive output waveforms from the DUT(s). The DIB includes one or more sockets 22 for electrically coupling the DUT pins to the tester channels, thereby providing a convenient tester-to-DUT signal interface.

In order to ensure that timing signals propagating along the channels arrive at the DUT pins within predefined accuracies, a plurality of high resolution skew detection circuits, generally designated 30, are employed. The skew detection circuits accurately measure both in-phase and out-of-phase channel-to-channel skews for timing calibration or verification purposes.

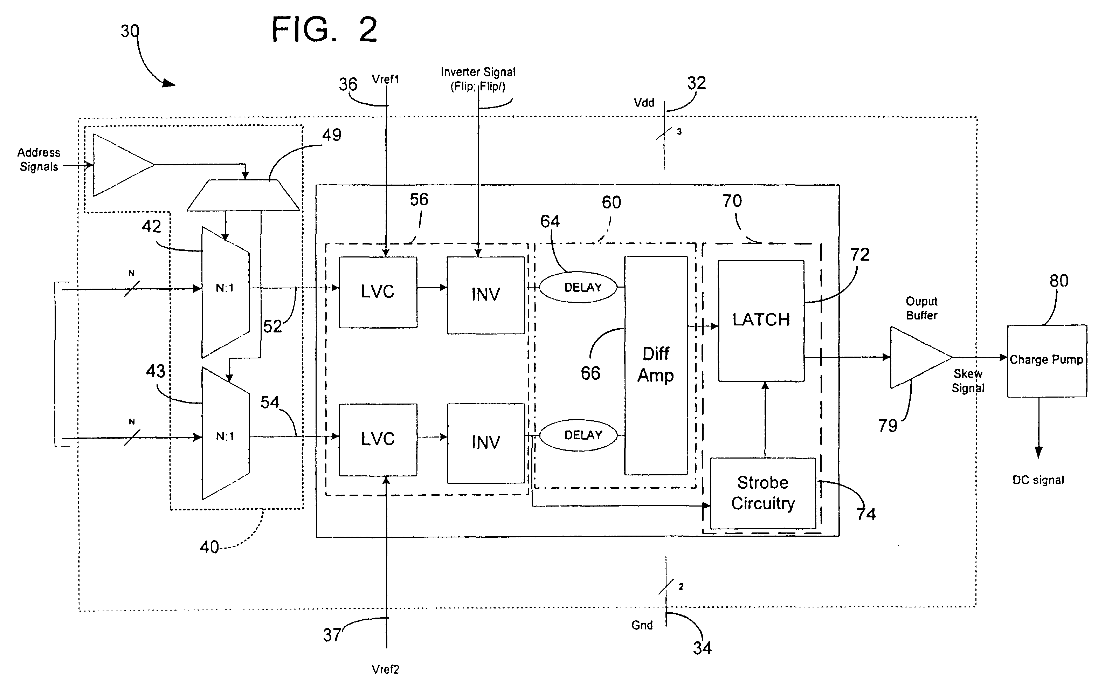

Referring more particularly to Figure 2, each skew detection circuit 30 takes the form of an application specific integrated circuit (ASIC). The ASIC includes bias inputs 32 and 34 for receiving Vdd and Vss signals, and first and second reference signal inputs 36 and 37 for receiving reference clock signals VREF1 and VREF2. Selector circuitry 40 is provided on the ASIC with inputs coupled to a plurality of tester channels, and outputs feeding a high resolution skew detector 50 for measuring signal-to-signal skews on the order of 1 picosecond.

Further referring to Figure 2, the selector circuitry 40 includes a pair of N:1 analog multiplexers 42 and 43 having inputs coupled to N (preferably twenty-four) tester channel transmission line outputs. An address decoder 49 responsive to multibit DC address signals provides respective control inputs to the multiplexers. The analog multiplexers allow a single ASIC to process several tester channels (in this example, twenty-four) to maximize tester throughput during the calibration and/or verification process.

The inventors have discovered that the construction of the analog multiplexers plays an important role in successfully maximizing the number of selectable inputs for the HRSD while maintaining acceptable signal quality. While conventionally, a parallel array of N number of MOS gates might be employed to carry out the multiplexing function, such a scheme often ties the gate outputs in parallel to produce a single output, thereby defining an N:1 device. Unfortunately, for high accuracy applications, the lumped output capacitance of all the gates in the conventional configurations often creates undesirable transients that affect the output signal integrity.

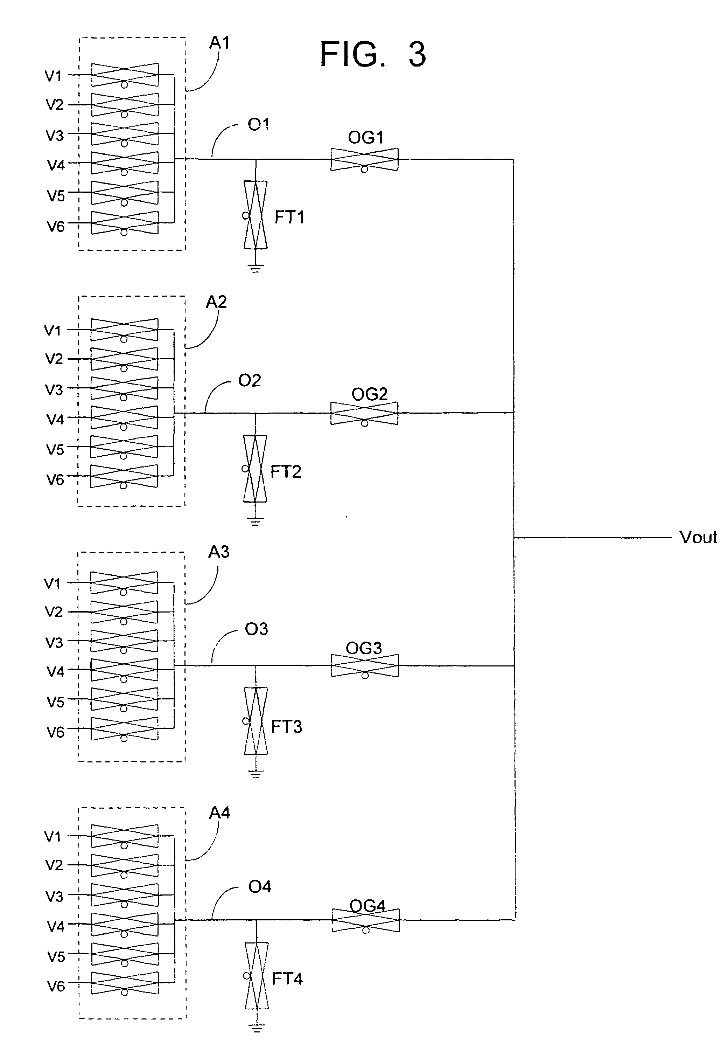

In an effort to minimize the transient effects noted above, and with particular reference to Figure 3, the analog multiplexers 42 and 43 each preferably include twenty-four MOS transmission gate inputs V I - V24, distributed in such a manner as to minimize capacitively coupled input-output transients. The input gates are grouped into four parallel arrays A1 - A4, with each array having a single output O1 - 04. Each output is fed to a series-connected output transmission gate OG1 - OG4. To channel the undesirable transient feedthrough signals to ground, respective grounded feedthrough transmission gates FT1 - FT4 shunt the signal output paths. The outputs of the output transmission gates are tied and provide a high fidelity output signal Vout to the input of the HRSD 50.

Referring back to Figure 2, the high resolution skew detector (HRSD) 50 generally employs multi-phase input circuitry 56 for receiving the tester signal and the reference signal, and time-to-voltage conversion circuitry 60 for generating an output signal representative of the relative skew between the tester signal and the reference signal. Capture circuitry 70 is disposed at the output of the time-to-voltage conversion circuitry to enable the detection of the generated output signal. The input circuitry and the time-to-voltage conversion circuitry define first and second signal paths 52 and 54 for the respective input signals. For purposes of clarity, only the first path will be described in detail below.

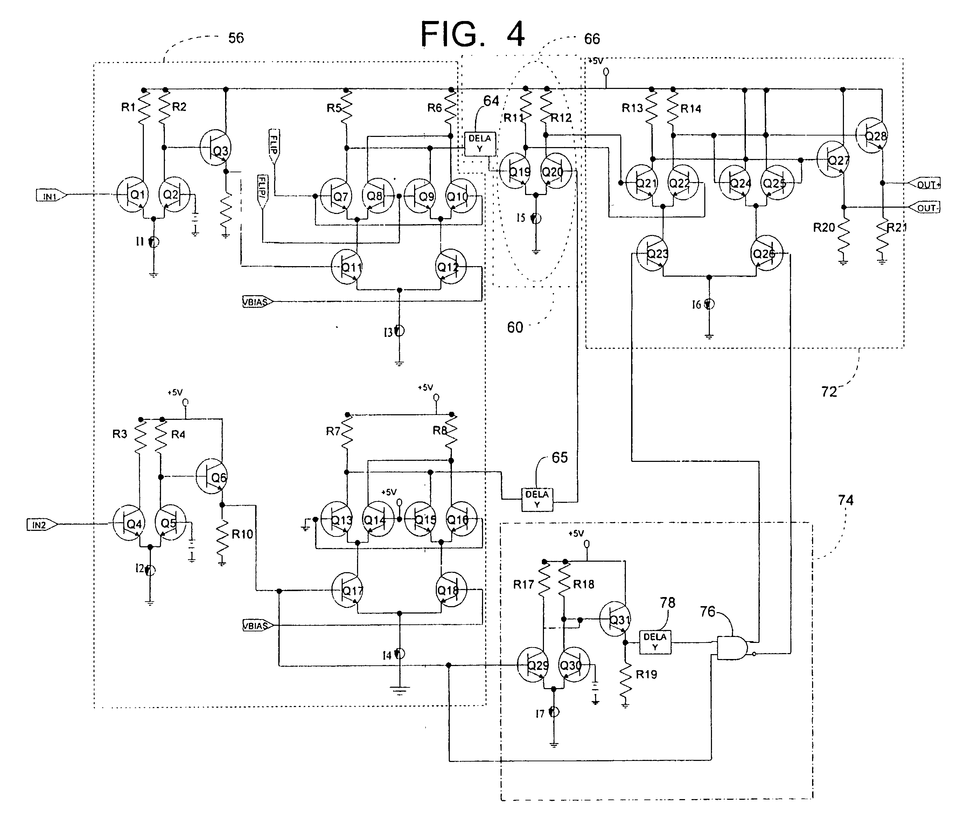

Referring more particularly now to Figure 4, the multi-phase input circuitry 56 for the first signal path 52 comprises a level voltage converter LVC1 (Fig. 2) for receiving the input signal IN 1 (the tester transmission line output signal from one channel) and reducing the input signal voltage swing to a level (such as 450 mV) more suitable for high-speed processing. The level converter includes a differential pair Q1, Q2 driven by a current source 11. The collector output of Q2 feeds an emitter follower Q3 that produces the reduced signal level, and provides an input to a Gilbert Inverter INV1.

The Gilbert inverter INV1 includes a differential control input (FLIP, FLIP/) fed to respective first and second differential pairs Q7, Q8 and Q9, Q 10. A third differential pair Q 11, Q12 couples to the emitters of the first and second differential pairs, and receives the level converted tester signal from the output of the level voltage converter LVC 1 and a bias signal VBIAS. Disposed at the emitter node of the third differential pair is a current source 13. Respective resistors R5 and R6 establish the DC biasing conditions for the inverter as is well known in the art. The collectors of the transistors Q7 and Q9 are tied to an output node that feeds the time-to-voltage conversion circuitry 60. The output of the circuit is responsive to the differential control signal FLIP, FLIP/ to either pass or invert the level converted tester input signal IN1. This conveniently provides for the measurement of in-phase and out-of-phase skews.

With further reference to Figure 4, the time-to-voltage conversion circuitry 60 includes a delay element 64 coupled to the output of the Gilbert inverter INV1, and a differential amplifier.

As alluded to above, the second signal path 54 includes level conversion circuitry LVC2 (transistors Q4 through Q6, and resistors R3 through R4) and a Gilbert inverter INV2 (transistors Q13 through Q18, current source 14, and resistors R8, R9) configured similar to that of the first path 52; and warrants no further description. However, the second signal path is sampled by the capture circuitry 70, at 62, (described below) to provide a self-clocking scheme that eliminates the need for additional clock circuitry.

The differential amplifier 66 includes another differential pair of transistors Q19 and Q20 driven by a current source I5, and receives the level converted and Gilbert inverted inputs to generate a differential signal having an amplitude proportional to the relative skew between the input signals IN 1 and IN2. The differential signal output is fed to the input of the capture circuitry 70.

Further referring to Figures 2 and 4, the capture circuitry 70 includes a latch block 72 clocked by a strobe pulse produced by strobe circuitry 74. The latch block includes an input differential pair Q21; Q22 having inputs coupled to the differential outputs of the differential amplifier 66. A second differential pair Q24, Q25 includes respective inputs cross-coupled to the outputs of the input differential pair to effectively create a D-type latch. A pair of emitter followers Q27 and Q28 provide a differential buffered output OUT+, OUT-. A third differential pair Q23, Q26 drives (or sources current from) the first and second differential pairs, and includes a current source 16. The third differential pair activates in response to differential input signals from the strobe circuitry 74.

With continuing reference to Figure 4, the strobe circuitry 74 includes an inverter module that feeds an AND/NAND gate 76. The inverter module comprises a differential pair Q29, Q30 that generates an inverted output fed to an emitter follower Q31. The inverted output is coupled through a delay element 78 to an input of the AND/NAND gate. A non-inverted version of the input signal is fed to a second input of the AND/NAND gate.

The construction of the AND/NAND gate 76 is of conventional ECL design, and well known to those skilled in the art.

Referring back to Figure 1, the output of the latch block 72 is preferably fed through an output buffer 79 to a charge pump or low pass filter 80. The charge pump or low pass filter generates a DC output in response to the latch signal. In this way, an off-chip DC voltage can be produced and quickly directed to a timing calibration or verification controller (not shown) that acquires the skew data for analysis.

As noted previously, to take advantage of the convenient interface provided by the DIB, and eliminate the need for an expensive and slow-performing robotic probe, the skew detection circuit of the present invention 30 is preferably disposed in integrated circuit form and packaged similar to that of a DUT. However, for devices having more than sixteen I/O pins; the present invention may be modularized as required in order to process the additional inputs. For example, since the preferred HRSD circuit 30 adequately steps through twenty-four channels (corresponding to twenty-four DUT I/O pins), for DUTs having 64 I/Os, three HRSD circuits may be implemented in a single ASIC. Consequently, to set-up the tester for timing calibration or verification, the ASIC packages are merely plugged into the DUT sockets to provide a complete external timing calibration or verification for a parallel array of device locations up to and including the socket traces.

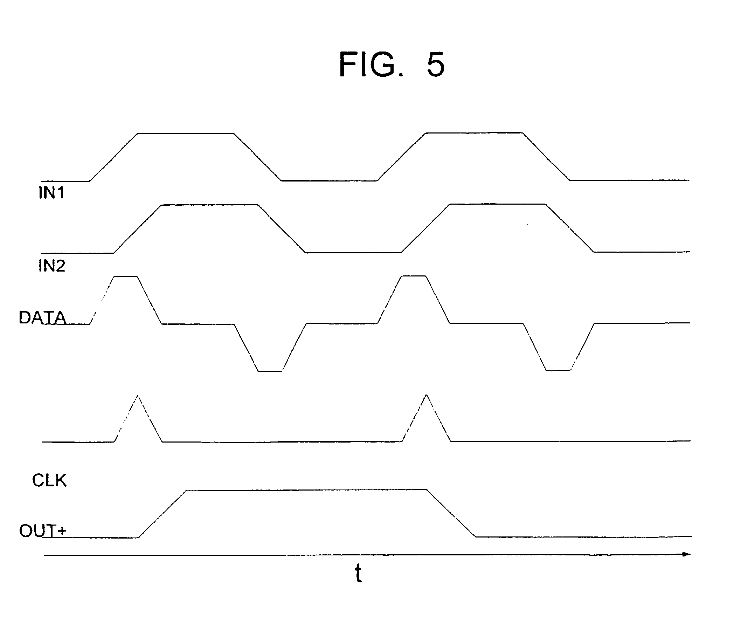

The operation of the present invention is best described with reference to Figures 1, 2,4 and the timing diagram of Figure 5. As previously described, the skew detection circuit 30 is preferably implemented as an ASIC, for installation into the socket of a DUT loadboard. In parallel memory test applications, the loadboard may include anywhere from thirty-two to one-hundred-twenty-eight device locations for high throughput parallel testing. The unique ASIC implementation allows for the installation of thirty-two to one-hundred-twenty-eight HRSD ASICs to carry out tester timing calibration and/or timing verification.

For purposes of clarity, the following description of operation will focus on a timing verification application, with the understanding that the method described is equally applicable to performing an initial timing calibration. A timing verification is merely an independent confirmation, or checkout, of the tester signal timing to ensure that the previously performed calibration resulted in timings within the required tolerance.

Once the HRSD ASICs are installed in the loadboard 14, the tester generates a predetermined test waveform pattern simulating actual tester operation. This involves the transmission of tester signals along the tester channels 20 to each of the ASIC signal inputs.

To detect and measure channel-to-channel skew, for instance between channel 1 and channels 2 through 16, tester signals along channel 1 are used as a signal reference IN2, while the remaining channels are sequentially passed through the selector 40 to the HRSD 50. The sequencing through the analog multiplexers 42 and 43 are regulated by the 4-bit DC address signals (controlled by a verifcation controller, not shown) that specify which channel signals the multiplexers should pass.

The selected tester signal IN1, and the reference signal (from channel 1 ) IN2, are then conditioned by the level voltage conversion circuitry LVC1 and LVC2 into approximately 450 mV signals. This reduces the logic swing levels, enabling faster circuit performance.

The respective level converted signals for IN 1 and IN2 are then processed as necessary by the Gilbert inverters INV 1 and INV2 so that out-of-phase as well as in-phase skews are detected and used as differential input signals to the differential amplifier 66. As shown in Figure 5, the differential amplifier produces an output signal pulse DATA having an amplitude proportional to the relative skew between IN 1 and IN2. Of particular importance is the generation of the output (for at least the duration of the input signal risetimes) even for relatively minute skew levels on the order of one picosecond. This provides a tremendous advantage in successfully detecting and measuring such small timing parameters.

In order to maintain the detected-amplifier output (representing the relative skew), the strobe circuitry 74 produces a one-shot clocking signal (a strobe pulse) CLK (Fig. 5) triggered by the rising edge of the reference signal input IN2. This self-timing feature results by sampling the reference signal IN2 at 62 (Fig. 4), and ANDing/NANDing the signal with an inverted version. The strobe clock CLK then causes the latch circuitry 72 to maintain or "latch" the data signal DATA for an extended duration, thereby generating easily detectable output signals OUT+ and OUT-.

The output signal pulse is then further processed through the charge pump or low-pass filter 80 to extract the DC signal component, and establish a readily processable off-chip skew signal for analysis by the timing verification controller. The generalized procedure above occurs simultaneously for all of the HRSD ASICs, and repeats after the reference channel signal is compared to all the other channels. A new channel then substitutes the previous reference channel, and the procedure repeated. Once the verification is complete, the tester may then proceed with production testing of semiconductor devices.

Those skilled in the art will appreciate the many benefits and advantages afforded by the present invention. Of particular importance is the high resolution detection ability for detecting both in-phase and out-of-phase skews. This provides a substantially improved measure of accuracy for detecting timing variations. This is extremely important for modem semiconductor testers that employ numerous differential channel configurations. Moreover, by implementing the unique selector circuitry, verification times are dramatically minimized, resulting in substantial cost savings by maximizing the availability of the tester for production operations and correspondingly increasing throughput.

While the invention has been particularly shown and described with reference to the preferred embodiments thereof, it will be understood by those skilled in the art that various changes in form and detail may be made therein without departing from the scope of the invention.

## Claims

1. A high resolution skew detector (50) including:
multi-phase input circuitry (56) having a reference signal input and a skew signal input, said skew signal input adapted for receiving in-phase and/of out of phase skew signals, said input circuitry operative to pass or invert said skew signals in response to a control signal;
time-to-voltage conversion circuitry (60) having respective first and second inputs for receiving said skew and reference signals, said time-to-voltage conversion circuitry including a differential amplifier (66) for generating a relative skew signal representing the relative skew between said reference signal and said skew signal; and
capture circuitry (70) coupled to the output of said time-to-voltage conversion circuitry (60) for detecting said relative skew signal.

2. A high resolution skew detector (50) according to claim I wherein said multi-phase input circuitry (56) further includes:
level conversion circuitry (LVC) for receiving and conditioning said respective skew and reference signals into respective level converted skew and reference signals.

3. A high resolution skew detector (50) according to claim 2 wherein said multiphase input circuitry (56) further comprises:
a first Gilbert inverter (INV) having a first input coupled to the output of said level conversion circuitry (LVC) and a second input responsive to a control signal to invert said skew signal; and
a second Gilbert inverter (INV) having a third input for receiving said level converted reference signal.

4. A high resolution skew detector (50) according to claim 1 wherein said capture circuitry (70) comprises:
strobe circuitry (74) coupled to said time-to-voltage conversion circuitry (60) and having a pulse generation circuit operative to produce a pulse of a predetermined width; and
latch circuitry (72) coupled to said differential amplifier output and responsive to said strobe circuitry timing to latch a signal indicative of the relative skew between said skew signal and said reference signal.

5. A high resolution skew detector (50) according to claim 4 wherein said produced pulse is synchronous with said reference signal.

6. A high resolution skew detector (50) according to claim 4 wherein said produced pulse is synchronous with said skew signal.

7. A high resolution skew detector (50) according to claim 1 wherein said reference signal input is coupled to a calibration signal source.

8. A high resolution skew detector (50) according to claim 1 wherein:
said skew signal input is coupled to a first tester channel; and
said reference signal input is coupled to a second tester channel.

9. A high resolution skew detector (50) according to claim 1 wherein:
said multi-phase input circuitry (56), said time-to-voltage conversion circuitry (60), and said capture circuitry (70) are disposed on an integrated circuit.

10. A high resolution skew detector (50) according to claim 9 and further including:
a signal converter (80) disposed at the output of said capture circuitry and having an output configured to provide an off-chip signal

11. A high resolution skew detector (50) according to claim 10 wherein:
said signal converter (80) comprises a charge pump.

12. A high resolution skew detector (50) according to claim 10 wherein:
said signal converter (80) comprises a low-pass filter.

13. A skew detection circuit (30) for measuring the relative skew between a plurality of propagating signals and a reference signal, said skew detection circuit including:
a selector circuit (40) having a plurality of inputs adapted for receiving said propagating signals and an output for selectively passing one of said plurality of signals for comparison with said reference signal; and
a high resolution skew detector (50) including
multi-phase input circuitry (56) having a reference signal input and a skew signal input, said skew signal input adapted for receiving in-phase and/or out of phase skew signals, said input circuitry operative to pass or invert said skew signals in response to a control signal;
time-to-voltage conversion circuitry (60) having respective first and second inputs for receiving said skew and reference signals, said time-to-voltage conversion circuitry including a differential amplifier(66) for generating a relative skew signal representing the relative skew between said reference signal and said skew signal; and
capture circuitry (70) coupled to the output of said time-to-voltage conversion circuitry for detecting said relative skew signal.

14. A skew detection circuit (30) according to claim 13 wherein:
said selector circuit (40) comprises an analog multiplexer (42), and said plurality of inputs comprise respective tester channels.

15. A skew detection circuit (30) according to claim 14 wherein said analog multiplexer (42) comprises:
a plurality of input gates (V1 - V24) corresponding to a plurality of input signals, said plurality of input gates arranged into an integral number of groups, each of said groups comprising a predetermined number of said input gates configured in parallel and having a common output;
a plurality of output transmission gates (OG1 - OG4) corresponding to the number of said common outputs, each of said plurality of output transmission gates coupled in series to said common outputs, and having respective output paths tied to form a single multiplexer output; and
a plurality of feedthrough transmission gates (FT1 - FT4) corresponding to the number of said common outputs, each of said plurality of feedthrough transmission gates having an input coupled to said common output and a grounded output.

16. A skew detection circuit (30) according to claim 13 wherein:
said selector circuit (40) and said high resolution skew detector (50) are disposed on an integrated circuit.

17. A method of determining the relative skew between a plurality of tester channels (20) to compensate for signal propagation delays, said method including the steps of:
generating tester signals along said plurality of channels;
coupling said channels to a high resolution skew detection circuit (30) comprising multi-phase input circuitry (56);
supplying a reference signal to said skew detection circuit;
selecting one of said tester signals;
using the multi-phase input circuitry to pass or invert said selected tester signal in response to a control signal;
comparing the selected tester signal against said reference signal on said skew detection circuit, said comparing step including the steps of:
converting the relative time difference between an edge of said reference signal and an edge of said passed tester signal to a voltage, and
providing said voltage at an output for use as a measurement of the relative skew between said tester signal and said reference signal.

## Patentansprüche

1. Hochauflösende Emrittlungsvorrichtung für Taktverschiebungen (50) mit:
einer Mehrphaseneingangsschaltungsanordnung (56) mit einem Referenzsignaleingang und einem Taktverschiebungssignaleingang, wobei der Taktverschiebungssignaleingang zum Empfangen von phasengleichen und/oder phasenverschobenen Taktverschiebungssignalen geeignet ist, wobei die Eingangsschaltungsanordnung funktionsfähig ist, das Taktverschiebungssignal als Antwort auf ein Steuersignal durchzulassen oder zu invertieren;
einer Schaltungsanordnung zur Zeit-Spannungsumsetzung (60) mit einem jeweiligen ersten und zweiten Eingang zum Empfangen des Taktverschiebungs- und des Referenzsignals, wobei die Schaltungsanordnung zur Zeit-Spannungsumsetzung einen Differenzverstärker (66) zur Erzeugung eines relativen Taktverschiebungssignals aufweist, der die relative Taktverschiebung zwischen dem Referenzsignal und dem Verschiebtmgssignal darstellt; und
einer ErFassuagsschaltungsanordnung (70), die mit dem Ausgang der Schaltungsanordnung zur Zeit-Spaunungsumsetzung (60) gekoppelt ist, zum Ermitteln des relativen Taktverschiebungssignals.

2. Hochauflösende Etmittlungsvorrichtung für Taktverschiebungen (50) nach Anspruch 1, wobei die Mehrphaseneingangsschaltungsanordnung (56) ferner aufweist:
eine Pegelumsetzungsschaltungsanordnung (LVC) zum Empfangen und Aufbereiten des jeweiligen Taktverschiebungs- und Referenzsignals zu einem jeweiligen pegelumgesetzten Taktverschiebungs- bzw. Referenzsignal.

3. Hochauflösende Ermittlungsvorrichtung für Taktverschiebungen (50) nach Anspruch 2, wobei die Mehrphaseneingangsschaltungsanordnung (56) femer umfaßt:
einen ersten Gilbett-Liverter (INV) mit einem ersten Eingang, der mit dem Ausgang der Pegelumsetzungsschaltung (LVC) gekoppelt ist, und einem zweiten Eingang, der auf ein Steuersignal anspricht, um das Taktverschiebungssignal zu invertieren; und
einen zweiten Gilbert-Inverter (INV) mit einem dritten Eingang zum Empfangen des pegelumgesetzten Referenzsignals.

4. Hochauflösende Ermittlungsvorrichtung für Taktverschiebungen (50) nach Anspruch 1, wobei die Fangschaltungsanordnung (70) umfaßt:
eine Strobeimpulsschaltvmgsanordnung (74), die mit der Schaltungsanordnung zur Zeit-Spannungsumsetzung (60) gekoppelt ist und eine Impulserzeugungsschaltung aufweist, die funktionsfähig, einen Impuls mit einer vorbestimmten Breite zu erzeugen; und
eine Zwischenspeicheranordnung (72), die mit dem Differenzverstärkerausgang gekoppelt ist und auf den Takt der Strobeimpulsschaltungsanordnung anspricht, um ein Signal zwischenzuspeichern, das die relative Taktverschiebung zwischen dem Taktverschiebungssignal und dem Referenzsignal anzeigt.

5. Hochauflösende Ermittlungsvorrichtung für Taktverschiebungen (50) nach Anspruch 4, wobei der erzeugte Impuls mit dem Referenzsignal synchron ist

6. Hochauflösende Ermittlungsvorrichtung für Taktverschiebungen (50) nach Anspruch 4, wobei der erzeugte Impuls mit dem Taktverschiebungssignal synchron ist.

7. Hochauflösende Ermittlungsvorrichtung für Taktverschiebungen (50) nach Anspruch 1, wobei der Referenzsignaleingang mit einer Kalibriersignalquelle gekoppelt ist.

8. Hochauflösende Ermittlungsvorrichtung für Taktverschiebungen (50) nach Anspruch 1, wobei:
der Taktverschiebungssignaleingang mit einem ersten Prüfgerät-Kanal gekoppelt ist; und
der Referenzsignaleingang mit einem zweiten Prüfgerät-Kanal gekoppelt ist.

9. Hochauflösende Ermittlungsvorrichtung für Taktverschiebungen (50) nach Anspruch 1, wobei:
die Mehrphaseneingangsschaltungsanordnung (56), die Schaltungsanordnung zur Zeit-Spannungsumsetzung (60) und die Erfassungsschaltangsanordnung (70) in einer integrierten Schaltung ausgeführt sind.

10. Hochauflösende Ermittlungsvorrichtung für Taktverschiebungen (50) nach Anspruch 9 und femer mit:
einem Signalumsetzer (80), der am Ausgang der Erfassungsschaltung angeordnet ist und einen Ausgang aufweist, der so konfiguriert ist, daß ein vom Chip abgehendes Signal bereitgestellt wird.

11. Hochauflösende Ermittlungsvonichtung für Taktverschiebungen (50) nach Anspruch 10, wobei:
der Signalumsetzer (80) eine Ladungspumpe umfaßt.

12. Hochauflösende Ermittlungsvorrichtung für Taktverschiebungen (50) nach Anspruch 10, wobei:
der Signalumsetzer (80) ein Tiefpaßfilter umfaßt.

13. Ermittlungsvorrichtung für Taktverschiebungen (30) zum Messen einer relativen Taktverschiebung zwischen einer Vielzahl von sich ausbreitenden Signalen und einem Referenzsignal, wobei die Schaltung zur Ermittlung von Taktverschiebungen aufweist
eine Selektorschaltung (40) mit einer Vielzahl von Eingängen, die zum Empfangen der sich ausbreitenden Signale geeignet sind, und einem Ausgang zum selektiven Durchlässen eines aus der Vielzahl von Signalen zum Vergleich mit dem Referenzsignal; und
eine hochauflösende Ermittlungsvorrichtung für Taktverschiebungen (50) mit
einer Mehrphaseningangsschaltungsanordnung (56) mit einem Referenzsignaleingang und einem Taktverschiebungssignaleingang, wobei der Taktverschiebungssignaleingang zum Empfangen von phasengleichen und/oder phasenverschobenen Taktverschiebungssignalen geeignet ist, wobei die Bingangsschaltungsanordnung funktionsfähig ist, die Taktverschiebungssignale als Antwort auf ein Steuersignal durchzulassen oder zu invertieren;
einer Schaltungsanordnung zur Zeit-Spannungsumsetzung (60) mit einem jeweiligen ersten und zweiten Eingang zum Empfangen des Taktverschiebungs- und des Referenzsignals, wobei die Schaltongsanordnung zur Zeit-Spannungsumsetzung einen Differenzverstärker (66) zum Erzeugen eines relativen Taktverschiebungssignals aufweist, das die relative Taktverschiebung zwischen dem Referenzsignal und dem Taktverschiebungssignal darstellt; und
einer Erfassungsschaltung (70), die mit dem Ausgang der Schaltungsanordnung zur Zeit-Spannungsumsetzung gekoppelt ist, zum Ermitteln des relativen Taktverschiebungssignals.

14. Ermittlungsvorrichtung für Taktverschiebungen (30) nach Anspruch 13, wobei:
die Selektorschaltung (40) einen analogen Multiplexierer (42) umfaßt und die Vielzahl von Eingängen entsprechende Prüfgerät-Kanäle umfassen.

15. Ermittlungsvorrichtung für Taktverschiebungen (30) nach Anspruch 14, wobei der analoge Multiplexierer (42) umfaßt:
eine Vielzahl von Eingangsgattern (V1-V24) entsprechend einer Vielzahl von Eingangssignalen, wobei die Vielzahl von Bingangsgattem in einer ganzzahligen Anzahl von Gruppen angeordnet ist, wobei jede der Gruppen eine vorbestimmte Anzahl der Eingangsgatter umfaßt, die parallel konfiguriert sind und einen gemeinsamen Ausgang aufweisen;
eine Vielzahl von Ausgangsübertragungsgattern (OG1-OG4) entsprechend der Anzahl der gemeinsamen Ausgänge, wobei jedes aus der Vielzahl von Ausgangsübertragungsgattern mit den gemeinsamen Ausgängen in Reihe geschaltet ist und deren entsprechende Ausgangswege so angeschlossen sind, daß sie einen einzigen Multiplexiererausgang bilden; und
eine Vielzahl von Durchführungsübertragungsgattern (FT1-FT4) entsprechend der Anzahl der gemeinsamen Ausgänge, wobei jedes aus der Vielzahl von Durchführungsübertragungsgattern einen Eingang, der mit dem gemeinsamen Ausgang gekoppelt ist, und einen geerdeten Ausgang hat.

16. Ermittlungsvorrichtung für Taktverschiebungen (30) nach Anspruch 13, wobei:
die Selektorschaltung (40) und die Ermittlungsvorrichtung für Taktverschiebungen (50) in einer integrierten Schaltung ausgeführt sind.

17. Verfahren zur Bestimmung der relativen Taktverschiebung zwischen einer Vielzahl von Prüfgerät-Kanälen (20), um Signallaufzeitverzögerungen zu kompensieren, wobei das Verfahren die folgenden Schritte aufweist:
Erzeugen von Prüfgerät-Signalen entlang der Vielzahl von Kanälen;
Koppeln der Kanäle mit einer hochauflösenden Schaltung zur Ermittlung von Taktverschiebungen (30) mit einer Memphaseneingangsschaltungsanordnung (56);
Zufuhren eines Referenzsignals zu der Schaltung zur Ermittlung von Taktverschiebungen;
Wählen eines der Prüfgerät-Signale;
Verwenden der Mehrphaseneingangsschaltungsanordnung, um das gewählte Prüfgerät-Signal als Antwort auf ein Steuersignal durchzulassen oder zu invertieren;
Vergleichen des gewählten Prüfgerät-Signals mit dem Referenzsignal in der Schaltungsanordnung zur Ermittlung von Taktverschiebungen, wobei der Vergleichsschritt die folgenden Schritte aufweist:
Umsetzen der relativen Zeitdifferenz zwischen einer Flanke des Referenzsignals und einer Flanke des durchgelassenen Prüfgerät-Signals in eine Spannung und
Bereitstellen der Spannung an einem Ausgang zur Verwendung als Maß für die relative Taktverschiebung zwischen dem Prüfgerät-Signal und dem Referenzsignal.

## Revendications

1. Détecteur de désalignement haute résolution (50) incluant:
un circuit d'entrée multi-phase (56) comprenant une entrée de signal de référence et une entrée de signal de désalignement, ladite entrée de signal de désalignement étant adaptée pour recevoir des signaux de désalignement en phase et/ou déphasés, ledit circuit d'entrée fonctionnant pour laisser passer ou inverser lesdits signaux de désalignement en réponse à un signal de commande;
un circuit de conversion temps-tension (60) comprenant des première et seconde entrées respectives pour recevoir desdits signaux de désalignement et de référence, ledit circuit de conversion temps-tension incluant un amplificateur différentiel (66) pour générer un signal de désalignement relatif représentant le désalignement relatif entre ledit signal de réfrénée et ledit signal de désalignement; et
un circuit de capture (70) qui est couplé à la sortie dudit circuit de conversion temps-tension (60) pour détecter ledit signal de désalignement relatif.

2. Détecteur de désalignement haute résolution (50) selon la revendication 1, dans lequel ledit circuit d'entrée multi-phase (56) inclut en outre:
un circuit de conversion de niveau (LVC) pour recevoir et conditionner lesdits signaux de désalignement et de référence respectifs selon des signaux de désalignement et de référence convertis en niveau respectifs.

3. Détecteur de désalignement haute résolution (50) selon la revendication 2, dans lequel ledit circuit d'entrée multi-phase (56) comprend en outre;
un premier inverseur de Gilbert (INV) comprenant une première entrée couplée à la sortie dudit circuit de conversion de niveau (LVC) et une seconde entrée sensible à un signal de commande pour inverser ledit signal de désalignement; et
un second inverseur de Gilbert (INV) comprenant une troisième entrée pour recevoir ledit signal de référence converti en niveau.

4. Détecteur de désalignement haute résolution (50) selon la revendication 1, dans lequel ledit circuit de capture (70) comprend:
un circuit de synchronisation (74) couplé audit circuit de conversion temps-tension (60) et comprenant un circuit de génération d'impulsion fonctionnant pour produire une impulsion d'une largeur prédéterminée; et
un circuit de verrouillage (72) couplé à ladite sortie d'amplificateur différentiel et sensible audit circuit de synchronisation qui effectue un cadencement pour verrouiller un signal indicatif du désalignement relatif entre ledit signal de désalignement et ledit signal de référence,

5. Détecteur de désalignement haute résolution (50) selon la revendication 4, dans lequel ladite impulsion produite est synchronisée avec ledit signal de référence.

6. Détecteur de désalignement haute résolution (50) selon la revendication 4, dans lequel ladite impulsion produite est synchronisée avec ledit signal de désalignement.

7. Détecteur de désalignement haute résolution (50) selon la revendication 1, dans lequel ladite entrée de signal de référence est couplée à une source de signal d'étalonnage.

8. Détecteur de désalignement haute résolution (50) selon la revendication 1, dans lequel:
ladite entrée de signal de désalignement est couplée à un premier canal de testeur; et
ladite entrée de signal de référence est couplée à un second canal de testeur.

9. Détecteur de désalignement haute résolution (50) selon la revendication 1, dans lequel:
ledit circuit d'entrée multi-phase (56), ledit circuit de conversion temps-tension (60) et ledit circuit de capture (70) sont disposés dans un circuit intégré.

10. Détecteur de désalignement haute résolution (50) selon la revendication 9, comprenant en outre:
un convertisseur de signal (80) disposé à la sortie dudit circuit de capture et ayant une sortie configurée pour fournir un signal hors puce.

11. Détecteur de désalignement haute résolution (50) selon la revendication 10, dans lequel:
ledit convertisseur de signal (80) comprend une pompe de charge.

12. Détecteur de désalignement haute résolution (50) selon la revendication 10; dans lequel:
ledit convertisseur de signal (80) comprend un filtre passe-bas.

13. Circuit de détection de désalignement (30) pour mesurer le désalignement relatif entre une pluralité de signaux de propagation et un signal de référence, ledit circuit de détection de désalignement comprenant:
un circuit de sélecteur (40) comprenant une pluralité d'entrées adaptées pour recevoir lesdits signaux de propagation et une sortie pour laisser passer de façon sélective l'un d'une pluralité de signaux pour une comparaison avec ledit signal de référence; et
un détecteur de désalignement haute résolution (50) incluant:
un circuit d'entrée multi-phase (56) comprenant une entrée de signal de référence et une entrée de signal de désalignement, ladite entrée de signal de désalignement étant adaptée pour recevoir des signaux de désalignement en phase et/ou déphasés, ledit circuit d'entrée fonctionnant pour laisser passer ou inverser lesdits signaux de désalignement en réponse à un signal de commande;
un circuit de conversion temps-tension (60) comprenant des première et seconde entrées respectives pour recevoir desdits signaux de désalignement et de référence, ledit circuit de conversion temps-tension incluant un amplificateur différentiel (66) pour générer un signal de désalignement relatif représentant le désalignement relatif entre ledit signal de référence et ledit signal de désalignement; et
un circuit de capture (70) qui est couplé à la sortie dudit circuit de conversion temps-tension pour détecter ledit signal de désalignement relatif.

14. Circuit de détection de désalignement (30) selon la revendication 13, dans lequel:
ledit circuit de sélecteur (40) comprend un multiplexeur analogique (42) et les entrées de ladite pluralité d'entrées comprennent des canaux de testeur respectifs.

15. Circuit de détection de désalignement (30) selon la revendication 14, dans lequel ledit multiplexeur analogique (42) comprend:
une pluralité de portes d'entrée (VI-V24) correspondant à une pluralité de signaux d'entrée, les portes de ladite pluralité de portes d'entrée étant agencées selon un certain nombre entier de groupes, chacun desdits groupes comprenant un nombre prédéterminé desdites portes d'entrée configurées en parallèle et ayant une sortie commune;
une pluralité de portes de transmission de sortie (OG1-OG4) correspondant au nombre desdites sorties communes, chacune de la pluralité de portes de transmission de sortie étant couplée en série auxdites sorties communes et ayant des voies de sortie respectives qui sont liées pour former une unique sortie de multiplexeur, et
une pluralité de portes de transmission de passage libre (FT1-FT4) correspondant au nombre desdites sorties communes, chacune de ladite pluralité de portes de transmission de passage libre ayant une entrée couplée à ladite sortie commune et une sortie reliée à la masse.

16. Circuit de détection de désalignement (30) selon la revendication 13, dans lequel:
ledit circuit de sélecteur (40) et ledit détecteur de désalignement haute résolution (50) sont disposés dans un circuit intégré.

17. Procédé de détermination du désalignement relatif entre une pluralité de canaux de testeur (20) pour compenser des retards de propagation de signal, ledit procédé comprenant les étapes de:
génération de signaux de testeur suivant ladite pluralité de canaux;
couplage desdits canaux à un circuit de détection de désalignement haute résolution (30) comprenant un circuit d'entrée multi-phase (56);
application d'un signal de référence sur ledit circuit de détection de désalignement;
sélection de l'un desdits signaux de testeur;
utilisation du circuit d'entrée multi-phase pour laisser passer ou inverser ledit signal de testeur sélectionné en réponse à un signal de commande;
comparaison du signal de testeur sélectionné vis-à-vis dudit signal de référence sur ledit circuit de détection de désalignement, ladite étape de comparaison incluant les étapes de:
conversion de la différence temporelle relative entre un front dudit signal de référence et un front dudit signal de testeur passé selon une tension; et
production de ladite tension au niveau d'une sortie pour une utilisation en tant que mesure du désalignement relatif entre ledit signal de testeur et ledit signal de référence.
